# EUROPEAN PATENT APPLICATION

(11) **EP 2 407 418 A2**
(43) Date of publication of application: **18.01.2012**
(21) Application number: 11005669.4
(22) Date of filing: 12.07.2011
(51) Int. Cl.: B81C 1/00

(54) **A MEMS device comprising a hermetically sealed cavity and devices obtained thereof**

(30) Priority: 15.07.2010 US 364561 P
(71) Applicant: Imec VZW, 3001 Leuven (BE)
(72) Inventor: Guo, Bin, 3001 Leuven (BE); Haspeslagh, Luc, 3210 Lubbeek-Linden (BE)
(74) Representative: Clerix, André

(57) **Abstract**

A MEMS device **1** is disclosed comprising a cavity **5** containing a MEMS component **6,** the cavity 5 being formed in a dielectric layer stack **3** having a thickness t_{d}, whereby the cavity **5** and the dielectric layer stack **3** are sandwiched between a substrate **2** and a sealing dielectric layer **4** having a thickness **tₛ,** and whereby the MEMS component **6** is enclosed by at least one trench **8** extending over the thickness t_{d} of the dielectric layer stack **3** and of the sealing dielectric **tₛ.**

## Description

### Field

The present disclosure relates to Micro Electro Mechanical systems, also known as MEMS devices, comprising a hermetically sealed cavity. In particular this disclosure relates to MEMS devices formed on a semiconductor-on-insulator (SOI) substrate.

### State of the art

Micro-Electro-Mechanical Systems (MEMS) refers to the integration of micromechanical components such as cantilevers, sensors, actuators, with electronics on a common substrate through microfabrication technology. The electronic components are fabricated using integrated circuit (IC) manufacturing technology, whereas the micromechanical components are fabricated using "micromachining" technology compatible with the electronic components. This micromachining technology selectively etches away parts of the substrate or adds new structural layers to form the micromechanical components.

The micromechanical components are contained in a cavity which, for many applications, needs to have a well controlled ambient. Hence this cavity should be hermetically sealed from the environment wherein the MEMS device is to operate. The sealing of the cavity is ideally done before the substrate is diced to yield the individual MEMS devices. Typically thin film capping is used to form a membrane overlying and sealing the cavity containing the MEMS component.

If the silicon layer of a Silicon-on-Insulator (SOI) substrate is used as structural layer for micromachining the MEMS component, the hermetic sealing of the cavity can be questioned. As the sidewalls of the cavity are, at least partly, formed in the silicon dioxide layer separating the silicon layer from the carrier substrate, these sidewalls will constitute leakage paths between the cavity and the environment in which the MEMS device is placed, e.g. during manufacturing or when in operation,

Silicon dioxide is known to have a low hermeticity as indicated by the low activation energy of 0.3eV for hydrogen diffusion. This hermeticity may even be further degraded during subsequent processing of the MEMS device. In addition silicon dioxide is known to absorb moisture and oxygen, even at room temperature.

Hence there is a need to form a hermetically sealed cavity, in particular when this cavity is, at least partly formed in a silicon dioxide layer.

### Summary

in an aspect the disclosure relates to a method for manufacturing a MEMS device comprising a hermetically sealed cavity containing a MEMS component whereby the method comprises providing a substrate having on a major surface a stack of a structural layer on a first dielectric layer, patterning the structural layer to form a MEMS component, forming a second dielectric layer overlying the MEMS component, forming a sealing dielectric layer overlying the second dielectric layer, forming in the stack of dielectric layers a trench extending to the substrate while enclosing the MEMS component, depositing a membrane layer overlying the sealing layer thereby filling the trench, and patterning the membrane layer thereby forming a membrane at the location of the MEMS component and an electrode covering the filled trench.

The structural layer can be a single layer or a stack of layer of semiconductive materials, such as silicon-germanium or silicon. Alternatively the structural layer can be a single layer or stack of layers of a conductive material such as titanium or nickel.

The method can further comprise removing the first and second dielectrics selective to the sealing dielectric layer, thereby creating underneath the membrane the cavity which contains now the MEMS component. In a particular embodiment openings are formed through the membrane and the sealing dielectric layer at the location of the MEMS component, through which openings the first and second dielectrics are then removed. After the removal of the first and second dielectrics these openings are sealed.

The sealing dielectric is preferably selected from the group of silicon-carbides or alumina-oxides when the first and second dielectrics are silicon-oxide.

The substrate can be a Semiconductor-On-Insulator (SOI) substrate, in which case the semiconductor layer thereof is the structural layer used for micromachining the MEMS component and the insulating layer separating the semiconducting layer from the substrate is the first dielectric layer. In case of a silicon-on-insulator substrate being a stack of a silicon layer, a silicon-oxide layer and a silicon carrier substrate, the silicon layer is used as structural layer and the silicon-oxide layer is used as first dielectric layer.

Preferably the membrane layer is formed in silicon-germanium SiₓGe₁₋ₓ with 0<x<1.

In another aspect the disclosure relates to a MEMS device comprising a hermetically sealed cavity containing a MEMS component, the cavity being formed in a dielectric layer stack having a thickness, whereby the cavity and the dielectric layer are sandwiched between a substrate and a sealing dielectric layer, and whereby the MEMS component is enclosed by a trench extending over the thickness of the dielectric layer stack.

The sealing dielectric is preferably selected from the group of silicon-carbides or alumina-oxides when the dielectric layer stack comprises or consists of silicon-oxide.

The MEMS device can further comprise a membrane covering the sealing layer at the location of the cavity, and an electrode covering and filling the trench. Preferably the membrane and electrode are formed in the same material. This material can be silicon-germanium.

### Brief description of the figures

Figure 1 shows a schematic cross-section of a partial processed MEMS device according to this disclosure.

Figure 2 shows a schematic top view of the MEMS device shown in figure 1.

Figure 3 shows a schematic cross-section of a MEMS device according to this disclosure.

Figure 4 shows a schematic cross-section of a MEMS device according to this disclosure

Figure 5 shows a schematic top view of a MEMS device shown in figure 4

Figure 6 shows a schematic cross-section of a MEMS device according to this disclosure

Figures 7-14 illustrate by means of schematic cross-sectional views process steps for manufacturing a MEMS device according to this disclosure.

Figures 15-16 illustrate by means of schematic cross-sectional views process steps for manufacturing a MEMS device according to this disclosure

The table below list the reference numbers used throughout the different figures:

**Table 1: list of reference numbers used**

| | | | |
|---|---|---|---|
| 1 | MEMS device | 11 | 1^{st} layer of dielectric stack 3 |
| 2 | carrier substrate | 12 | 2^{nd} layer of dielectric stack 3 |
| 3 | dielectric stack wherein cavity 5 is created | 13 | Isolation trench in membrane-electrode layer 18 |
| 4 | sealing dielectric | 14 | membrane sealing |
| 5 | cavity comprising MEMS components 6 | 15 | metal contact to electrode 8,10 |
| 6 | MEMS component | 16 | structural layer for forming MEMS component 6 |
| 7 | membrane overlying cavity 5 | 17 | release opening in membrane 7 |
| 8 | trench through sealing dielectric 4 and dielectric stack 3 exposing part of the carrier substrate 2 | 18 | membrane - electrode layer |
| 9 | electrode to carrier substrate 2 | 19 | opening trough sealing dielectric 4 and dielectric stack 3 exposing part of MEMS component 6 |
| 10 | electrode to MEMS component 6 | 20 | trench sealing |
| 21 | Opening through sealing dielectric 4 and dielectric stack 3 exposing part of the carrier substrate 2 | | |

### Detailed description

The present invention will be described with respect to particular embodiments and with reference to certain drawings but the invention is not limited thereto but only by the claims. The drawings described are only schematic. In the drawings, the size of some of the elements may be exaggerated and not drawn on scale for illustrative purposes. The dimensions and the relative dimensions do not necessarily correspond to actual reductions to practice of the invention.

Furthermore, the terms first, second, third and the like in the description and in the claims, are used for distinguishing between similar elements and not necessarily for describing a sequential or chronological order. The terms are interchangeable under appropriate circumstances and the embodiments of the invention may operate in other sequences than described or illustrated herein.

Moreover, the terms top, bottom, over, under and the like in the description and the claims are used for descriptive purposes and not necessarily for describing relative positions. The terms so used are interchangeable under appropriate circumstances and the embodiments of the invention described herein may operate in other orientations than described or illustrated herein.

The term "comprising", used in the claims, should not be interpreted as being restricted to the elements or steps listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the disclosure and claims, at least the components A and B are part of the device.

In an aspect the disclosure relates to a MEMS device **1** comprising a cavity **5** containing a MEMS component **6,** the cavity **5** being formed in a dielectric layer stack **3** having a thickness **tₐ**, whereby the cavity **5** and the dielectric layer stack **3** are sandwiched between a substrate **2** and a sealing dielectric layer **4** having a thickness **tₛ,** and whereby the MEMS component **6** is enclosed by at least one trench **8** extending over the thickness **t_{d}** of the dielectric layer stack **3** and of the sealing dielectric **tₛ.**

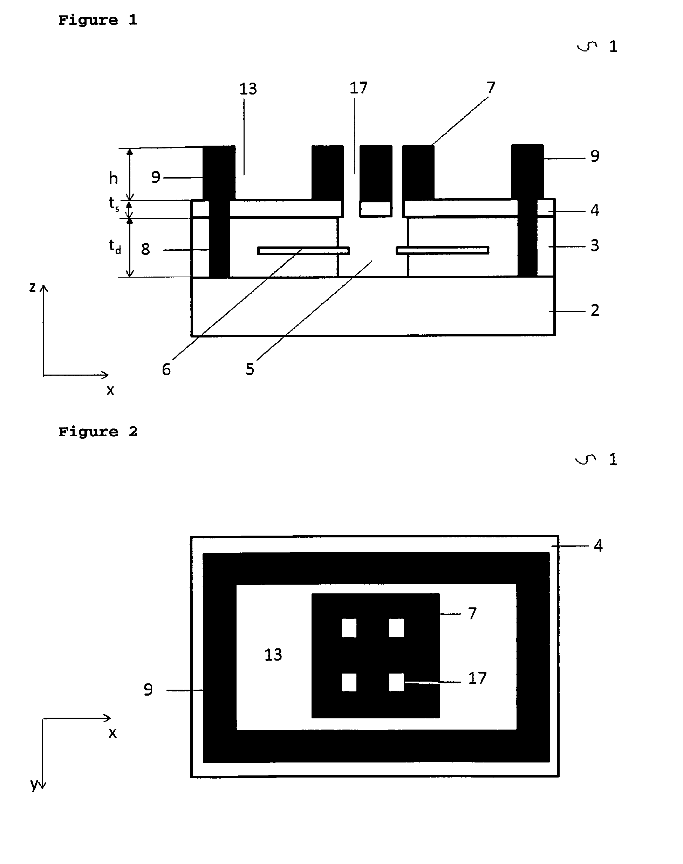

Such a device is illustrated by figures 1 to 3. The cavity **5** is created in a dielectric layer stack **3.** A MEMS component **6,** e.g. a cantilever, extends from this dielectric layer stack **3** into the cavity **5.** A membrane **7** overlies and seals the cavity **5** which is accessible via openings **17** in the membrane **7.** At least one electrode **9** contacts the carrier substrate **2** via a trench **8** through the dielectric layer stack **3.** The electrode **9** is separated from the membrane **7** by an isolation trench **13.**

In order to preserve the ambient within the cavity **5** and to prevent leakage from the environment through the dielectric stack **3** into the cavity **5,** in particular during operation of the MEMS device **1,** that part of the dielectric stack **3** containing the MEMS component **6** and the cavity **5** is bordered by materials providing a better sealing, at least towards hydrogen, than the dielectric stack **3**.

In a direction **z** perpendicular to substrate **2** this sealing is provided for by the carrier substrate 2 at one side and by the sealing dielectric **4** and the membrane **7** on the opposite side. The sealing dielectric **4** is on the dielectric stack **3** while the membrane **7** is on the sealing dielectric **4.** As shown in figure **2** the openings **17** in the membrane **7,** extending to the sealing dielectric **4,** are closed by a membrane sealing **14.** As the sealing dielectric **4** is covering the dielectric stack **3,** it provides a uniform sealing thereof at this side. If openings **8, 17** are created in this sealing dielectric **4**, these openings are further sealed by e.g. the electrode **9** and by the membrane sealing **14**.

In a direction **x** parallel to the substrate **2** this sealing is provided for by at least one trench **8** extending at least over the thickness **t_{d}** of the dielectric stack **3**. This trench **8** encircles the MEMS component **6** and is filled with a material different than the material of the dielectric stack **3**.

Figure 2 shows a schematic top view of the MEMS device 1 of figure 1. on the sealing dielectric 4 the membrane 7 and the electrode 9 can be seen. The membrane **7** contains openings **17** to the cavity **5.** As explained in the other aspect of the disclosure, these openings **17** allow selective removal of the dielectric stack **3** at the location of the MEMS component **6** to create the cavity **5** thereby releasing the MEMS component **6.** The layout of the membrane **7** may depend on the MEMS device **1** to be formed and is not limited to the particular design shown in figure 2. Likewise the number, distribution and layout of the openings **17** may depend on the MEMS device **1** and are not limited to the particular design shown in figure 2.

Surrounding the membrane **7** and spaced apart there from by an isolation trench **13,** the electrode **9** is present configured as a closed ring. The layout of the electrode **9** and of the trench **8** filled by this electrode **9** may depend on the MEMS device **1** to be formed and is not limited to the particular design shown in figure 2. This electrode **9** can be used to bias the substrate **2,** e.g. to provide a ground-connection to the substrate.

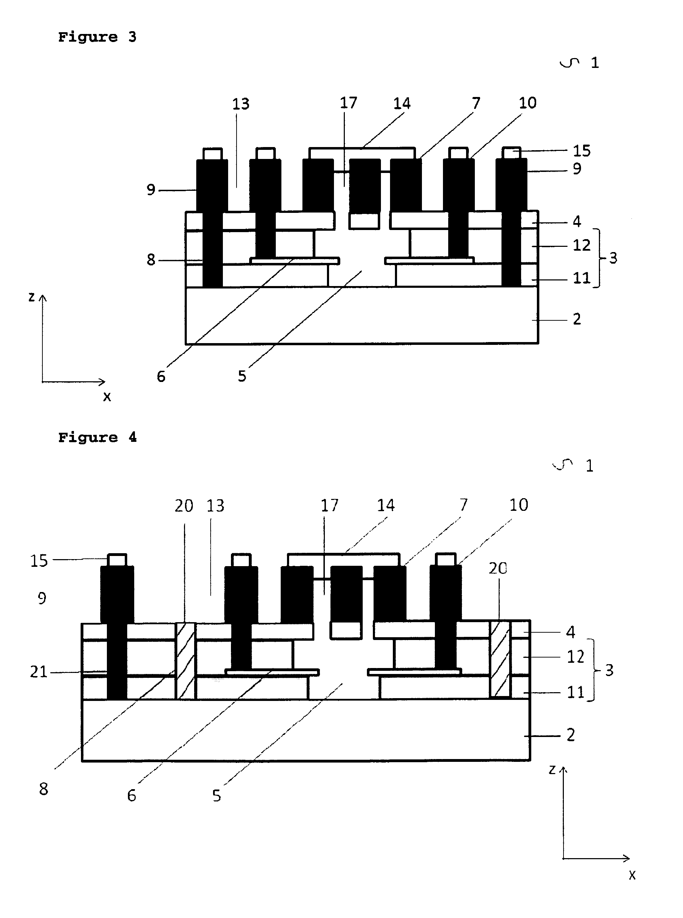

Figure 3 shows a schematic cross-section of a MEMS device 1. In addition to the MEMS device shown in figures 1 and 2, also an electrode **10** to the MEMS component **6** can be present. This electrode **10** can be used to supply voltages to the MEMS component **6.** A metallic contact 15 is formed on the MEMS component electrode **10** and on the substrate electrode **9** to obtain a better electrical contact with the electrode material. Openings **17** in the membrane **7** are closed by a membrane sealing **14.**

The sealing dielectric **4** is preferably selected from the group of silicon-carbides or alumina-oxides when the dielectric layer stack **3** comprises or consists of silicon-oxide. The latter may be the case if a semiconductor-on-insulator substrate is used for micromachining the MEMS component **6**. A semiconductor-on-insulator substrate is composed of a thin semiconductor layer isolated from a thicker semiconductor substrate by a dielectric layer. Typically this semiconductor substrate is a silicon substrate, whereby this dielectric layer is a silicon-oxide layer. The MEMS component is micromachined in the thin semiconductor layer which is used as structural layer **16**. The insulating layer becomes part of the dielectric stack **3**, and, when it is formed of silicon-oxide, it may constitute a leakage path.

Compared with the 0.3eV activation energy of silicon-oxide, materials such as silicon-carbide, e.g. Sic, and alumina-oxide, e.g. Al₂O₃, have a relatively high activation energy, respectively 3eV and leV, for the diffusion of hydrogen. This activation energy can be increased by densifying the silicon-oxide, but this would require temperatures above 500°C which is incompatible with MEMS micromaching.

The membrane **7** and the electrode **9** are preferably formed in the same material, preferably in the same layer of material. This membrane and electrode material can be silicon-germanium SiₓG₁₋ₓ with 0<x<1.

If the membrane **7** and the electrode **9** are formed in the same layer, they will protrude to the same height **h** from the sealing dielectric **4.** The upper surfaces of the membrane 7 and the electrode **9** are then coplanar.

In the figures 1 to 3 only one sealing trench **8** is shown. The sealing efficiency can be further improved if more than one sealing trench **8** filled with electrode material encircles the MEMS component **6.** Preferably these sealing trenches **8** are concentric with the cavity **5**. These sealing trenches **8** can be overlapped by a single electrode **9** or every trench **8** can be overlapped by a separate electrode **9.**

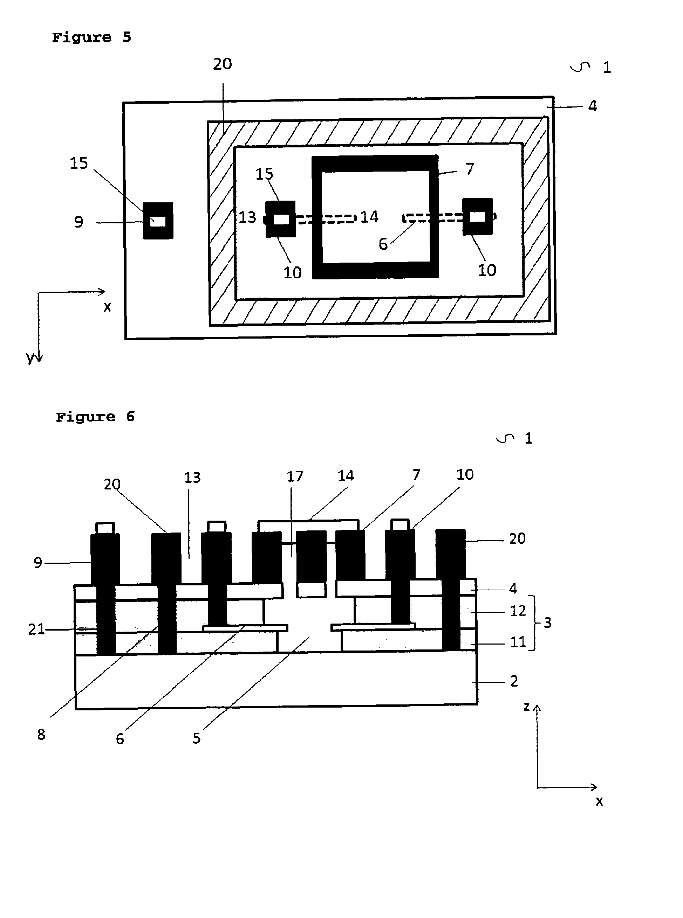

In the MEMS devices **1** illustrated by figures 1 to 3 the electrode **9** filling the trench **8** provided at the same time an electrical contact to the substrate **2** and an improved sealing in lateral direction of the enclosed cavity **5.** In the MEMS device illustrated by figures 4 to 6 the electrical substrate contact and the lateral cavity sealing are formed respectively in an opening **21** and in trench **8.** In addition to the MEMS device **1** shown in figure 3, the MEMS device **1** of figure 4 contains a substrate electrode **9** and a filled sealing trench **20.** The top view in figure 5 illustrates that the filled sealing trench **20** encircles the MEMS component **6,** shown by the dotted line. By creating an opening **21** and a trench **8** one can individually optimize the layout of the trench **8 -** opening 21 and/or the fill material **9, 20** in function of the required functionality such as electrical contact, sealing properties. The sealing trench **20** can be filled up to the upper surface of the sealing dielectric **4** as shown in figure 4 or can extend above the sealing dielectric **4.**

In the MEMS device 1 illustrated by figures 4 and 5 the trench **8** surrounding the MEMS **component 6** was filled **20** with a material other than the material used to form the substrate electrode **9** and/or the membrane **7.** For ease of processing, one might still choose to use the same material to fill the substrate electrode trench **8-9**, the sealing trench **8-20**, the MEMS component trench **19** and to form the membrane **7** as shown in figure 6.

In another aspect the disclosure relates to a method of manufacturing a MEMS device 1 comprising a cavity **5** containing a MEMS component **6,** the cavity **5** being formed in a dielectric layer stack **3** having a thickness t₄, whereby the cavity **5** and the dielectric layer stack 3 are sandwiched between a substrate **2** and a sealing dielectric layer **4** having a thickness **tₐ,** and whereby the MEMS component **6** is enclosed by at least one trench **8** extending over the thickness **t_{d}** of the dielectric layer stack **3** and of the sealing dielectric **tₛ.**

The method comprises providing a substrate **2** having upon a major surface a dielectric layer stack **3**, whereby a MEMS component **6** is embedded in the dielectric stack **3.** The method further comprises forming a sealing dielectric **4** overlying the dielectric stack, forming at least one trench **8** enclosing the MEMS component **6** and extending to the substrate **2** and filling the trench **8** with a material different from the dielectric stack **3.**

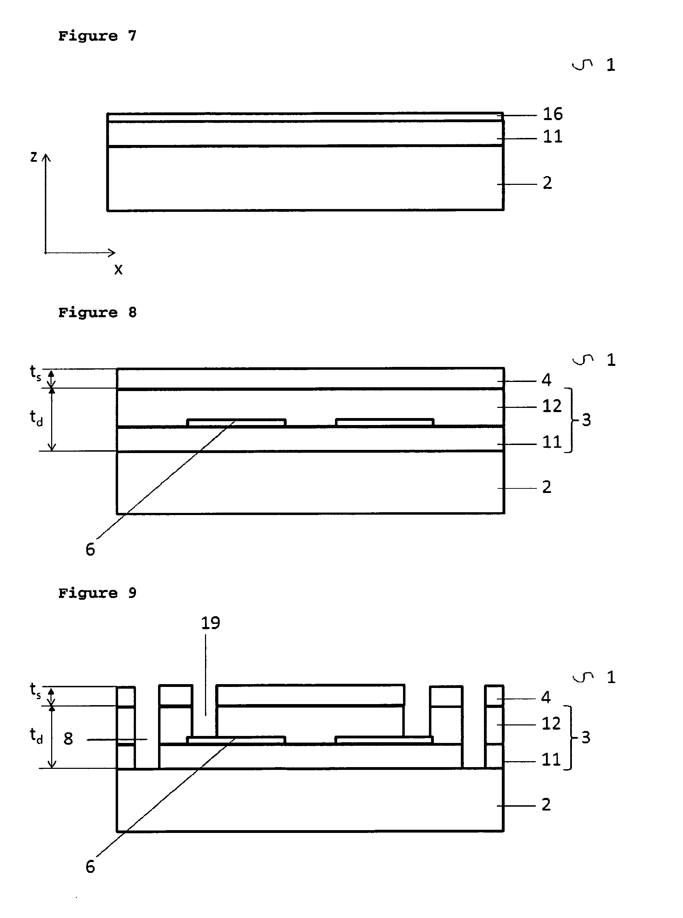

Figures 7 to 14 illustrate a method for manufacturing such a MEMS device **1.**

On a substrate **2** a first dielectric layer **11** is formed. On this dielectric layer **11** a structural layer **16** is formed. Such a layered substrate is illustrated by figure 7, The layered substrate can be a semiconductor-on-insulator substrate composed of a thin semiconductor layer isolated from a thicker semiconductor substrate by a dielectric layer. Typically this semiconductor substrate is a silicon substrate, whereby this dielectric layer is a silicon-oxide layer. The MEMS component will then be micromachined in the thin semiconductor layer which is used as structural layer **16**. The insulating layer will constitute the first dielectric layer 11 and become part of the dielectric stack **3,** and, when formed of silicon-oxide, it may constitute a leakage path.

The structural layer **16** is patterned to form the MEMS component **6.** The layout of this MEMS component **6** may depend on the MEMS device **1** to be formed and is not limited to the particular design shown in figures 7-14. overlying this MEMS component a second dielectric layer **12** is formed. This second dielectric layer 12 can comprise or consist of silicon-oxide. The first **11** and second **12** dielectric layers form the dielectric stack **3** having a thickness **t_{d}.**

On this dielectric stack **3** the sealing dielectric **4** is formed having a thickness **t₂.** This sealing dielectric **4** provides a uniform sealing of the upper surface of this dielectric stack **3.** As shown in figure 8 the dielectric stack **3,** wherein the MEMS component **6** is embedded, is sandwiched between the substrate **2** and the sealing dielectric **4** thereby providing sealing of the dielectric stack **3** in a direction z perpendicular to the substrate **2.**

The sealing dielectric **4** is preferably selected from the group of silicon-carbides or alumina-oxides when the dielectric layer stack **3** comprises or consists of silicon-oxide.

Compared with silicon-oxide, materials such as silicon-carbide, e.g. SiC, and alumina-oxide, e.g. Al₂O₃, have a relatively high activation energy, respectively 3eV and leV, for the diffusion of hydrogen.

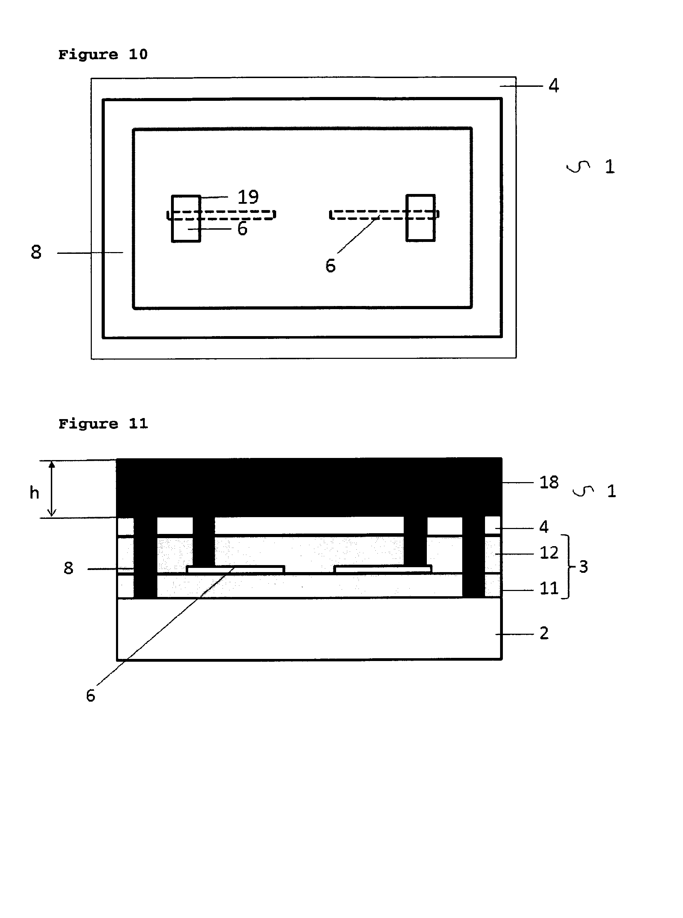

Openings **8** are formed in the sealing dielectric **4** and in the dielectric stack **3** to expose part of the substrate **2.** If needed, also openings **19** can be formed in the sealing dielectric **4** and the dielectric stack 3 to expose part of the MEMS component **6** as shown in figure 9. The top view shown in figure 10 clearly illustrates that the opening **8** is a trench configured as a closed ring surrounding the MEMS component **6** (indicated by the dotted line) while the opening **19** is a hole providing access to the MEMS component **6.**

After creating the trench **8** this trench is filled and a membrane **7** is formed on the sealing dielectric **4** at the location where the cavity **5** is to be formed.

The membrane **7** and the trench fill are preferably formed in the same material, preferably in the same layer of material. This membrane and trench fill material can be silicon-germanium SiₓG₁₋ₓwith 0<x<1.

Figure 11 illustrates the case where the membrane **7** and the trench fill are formed in the same layer of material **18.** All openings **8, 19** are filled when depositing this layer **18** having a height **h** above the sealing dielectric **4.**

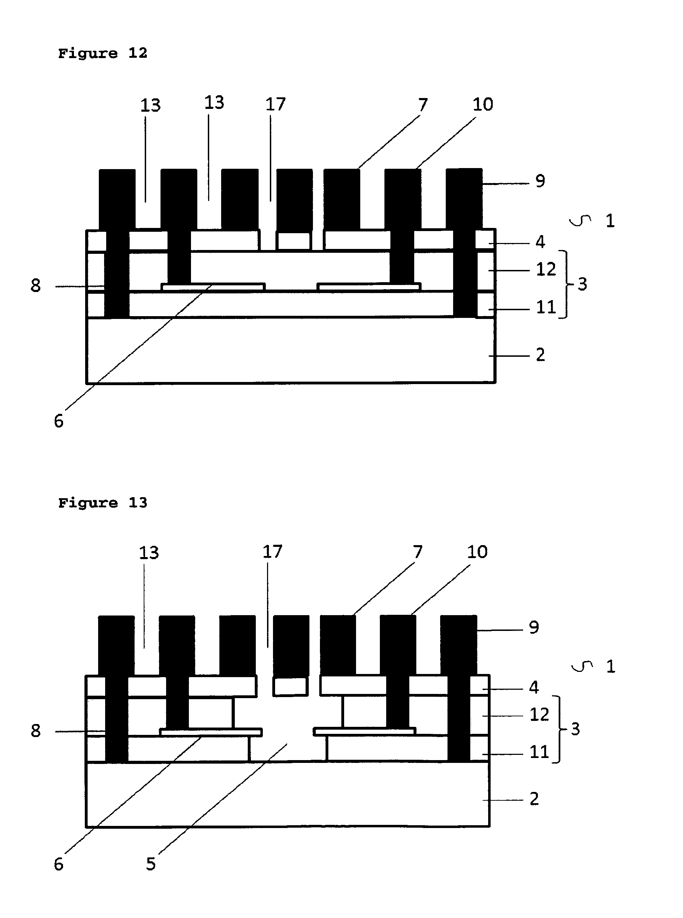

After depositing the layer **18** as shown in figure 10, this layer **18** is patterned to create the membrane **7,** the electrode **9** filling and overlying the sealing trench **8** and the electrode **10** filling and overlying the opening **19.** The membrane **7** and the electrodes **9, 10** are mutually isolated by the isolation trenches **13** exposing the sealing layer **4.** No leakage towards the cavity **5** can occur via these isolation trenches **13** as at the bottom thereof the sealing dielectric **4** is present aligned to and even extending beyond the area of the isolation trench **13** as shown in figure 12.

The openings **17** in the membrane **7** are extended through the sealing dielectric **4** thereby exposing the dielectric stack **3** as shown in figure 12. Through these openings the dielectric stack **3** can be locally removed thereby creating the cavity **5** and releasing the MEMS component **6** as shown in figure 13. As the sealing dielectric **4** provides sealing functionality also in the areas outside the membrane **7,** the cavity can extend even beyond the area of the membrane **7** thereby giving more freedom in the layout and the position of the membrane **7.**

The dielectric stack **7** must be removed selectively with respect to the sealing dielectric **4** in order not to affect the sealing functionality thereof. If the sealing dielectric **4** is selected from the group of silicon-carbides or alumina-oxides and the dielectric layer stack **3** comprises or consists of silicon-oxide, the openings **17** in the sealing dielectric **4** can be created by dry etch stopping on the dielectric stack **3** while selective removal of this dielectric stack **3** can be done using a wet or vapor phase HF based etchant.

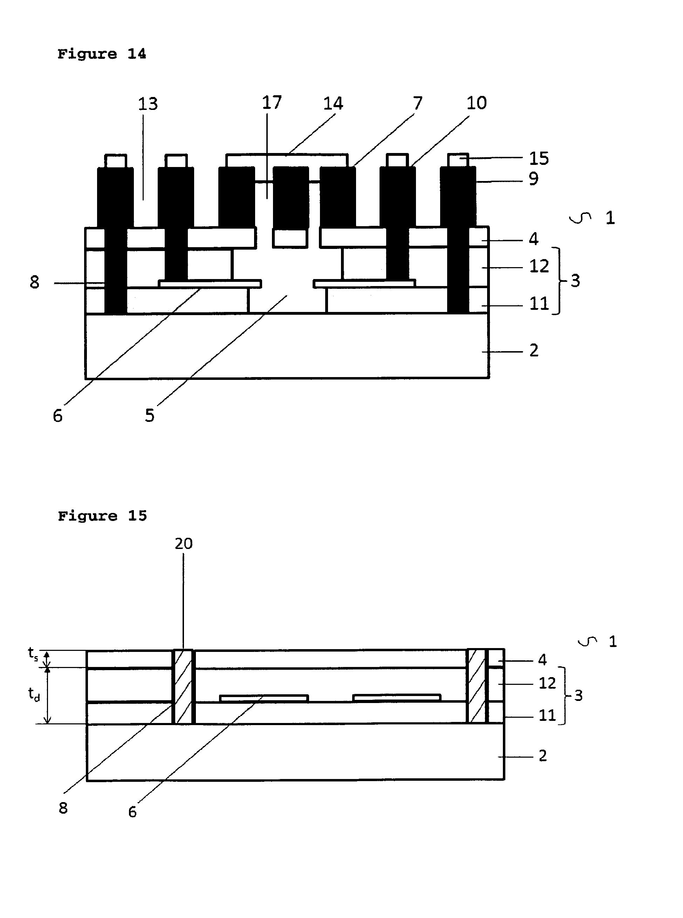

After releasing the MEMS component **6**, the sealing of the cavity **5** is finished by a sealing process forming a sealing **14** covering the release holes **17** in the membrane **7** as shown in figure 14.

The process sequence illustrated by figures **7** to 14 needs to be slightly modified if MEMS devices **1** as shown in figures 4 to 5 or 6 are to be manufactured.

If a MEMS device according to figure 6 is to be fabricated, the patterning step as shown in figure 9 is slightly modified. The patterning step then also includes forming a dielectric opening **21** for receiving the membrane - electrode layer **18** during the deposition thereof.

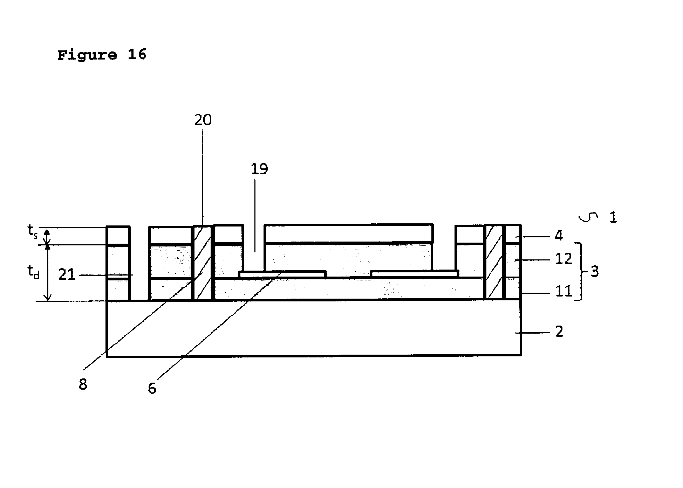

If a MEMS device 1 according to figures 4-5 to be fabricated, at least one additional patterning step and deposition step is to be included in the process flow. After depositing the sealing dielectric **4** a patterning step is performed to create the sealing trench **8.** The sealing trench **8** will be filled 20 with a material providing the desired sealing properties and being compatible with the MEMS processing, The filled trench **20** is planar with the sealing dielectric **4.** Figure 15 illustrate the MEMS device after creating and filling the sealing trench **8.** Then the process flow can be continued by patterning the dielectric opening **21** for receiving the substrate electrode **9** and the contact opening **19** for receiving the MEMS component electrode **10** as shown in figure 16. The membrane-electrode layer **18** is deposited thereby filling the openings **19** and 21 as is done in figure 11.

A hermetic sealed cavity **5** is thus fabricated eliminating the possible leakage paths due to the presence of silicon-oxide in the dielectric stack **3.** In addition this sealing also can provide an electrical connection **9** to the substrate **2.**

Further processing of the sealed MEMS device **1** can be done using known manufacturing techniques to provide e.g., forming the electrical connections **15** to the electrodes **9**, **10** and dicing of the individual packaged MEMS devices.

## Claims

1. A method for manufacturing a MEMS device (1) comprising a hermetically sealed cavity (5) containing a MEMS component (6), the method comprising;
- providing a substrate (2) having, on a major surface, a stack of a structural layer (16) on a first dielectric layer (11),
- patterning the structural layer (16) to form a MEMS component (6),
- forming a second dielectric layer (12) overlying the MEMS component (6),
- forming a sealing dielectric layer (4) overlying the second dielectric layer (12),
- forming, in the stack (3) of dielectric layers (4, 11, 12), a trench (8) enclosing the MEMS component (6) thereby extending to the substrate (2),
- depositing a membrane layer (18) overlying the sealing layer (4) thereby filling the trench (8), and;
- patterning the membrane layer (18) thereby forming a membrane (7) at the location of the cavity (5) and an electrode (9) covering the filled trench.

2. The method of claim 1, further comprising removing the first (11) and second (12) dielectrics selective to the sealing dielectric layer (4), thereby forming the cavity (5) which contains the MEMS component (6).

3. The method of claim 2, further comprising forming openings (17) through the membrane (7) and the sealing dielectric layer (4) at the location of the MEMS component (1), through which openings (17) the first (11) and second dielectrics (12) are removed.

4. The method of claim 2 or 3, further comprising closing (14) the openings (17) in the membrane (7) after the selective removal of the first (11) and second (12) dielectric.

5. The method of claim 1, 2, 3 or 4 wherein the sealing dielectric (4) is selected from the group of silicon-carbides or alumina-oxides, and the first (11) and second dielectrics (12) are silicon-oxide.

6. The method of claim 1, 2, 3, 4, or 5 wherein the membrane layer (18) is a silicon-germanium layer.

7. The method of claim 1, 2, 3, 4, 5, or 6 wherein the substrate (2) is a semiconductor-On-Insulator (SOI) substrate and the semiconductor layer thereof is the structural layer (16).

8. A MEMS device (1) comprising a hermetically sealed cavity (5), containing a MEMS component (6), formed in a dielectric layer stack (3) having a thickness (t_{d}), whereby the cavity (5) and the dielectric layer (6) are sandwiched between a substrate (2) and a sealing dielectric layer (4), and whereby the MEMS component (6) is enclosed by a trench (8) extending over the thickness (t_{d}) of the dielectric layer stack (3),

9. The MEMS device (1) of claim 8, wherein the sealing dielectric (4) is selected from the group of silicon-carbides or alumina-oxides and the dielectric layer stack (3) comprises silicon-oxide.

10. The MEMS device (1) of claim 8 or 9 further comprising a membrane (7) covering the sealing layer (4) at the location of the cavity (5) and an electrode (9) covering and filling the trench (8).

11. The MEMS device (1) of claim 10, whereby the membrane (7) and electrode (8) are formed in the same material (18).

12. The MEMS device (1) of claim 11 whereby this same material (18) is silicon-germanium.
